# EUROPEAN PATENT APPLICATION

(11) **EP 3 128 336 A1**
(43) Date of publication of application: **08.02.2017**
(21) Application number: 16182681.3
(22) Date of filing: 04.08.2016
(51) Int. Cl.: G01R 33/3815, H01F 6/00

(54) **LAMINATED AND FIXED STRUCTURE OF SUPERCONDUCTING BULK BODY AND MAGNETIC FIELD GENERATING APPARATUS**

(30) Priority: 06.08.2015 JP 2015155619
(71) Applicant: Hitachi, Ltd., Tokyo 100-8280 (JP)
(72) Inventor: MATSUDA, Kazuya, Tokyo 100-8280 (JP)
(74) Representative: MERH-IP Matias Erny Reichl Hoffmann Patentanwälte PartG mbB

(57) **Abstract**

Provided is a laminated and fixed structure of a plurality of superconducting bulk bodies (2a-2c), in which a fixing ring (5, 5a-5ac) which is provided for each superconducting bulk body (2, 2a-2c) and fixed to an outer periphery of the superconducting bulk body (2, 2a-2c) includes a screw portion, and the adjacent bulk bodies (2a-2c) are laminated and fixed by fitting the screw portions of the adjacent fixing rings (5, 5a-5ac) at the time of laminating.

## Description

### BACKGROUND OF THE INVENTION

### FIELD OF THE INVENTION

The present invention relates to a magnetic field generating apparatus.

### BACKGROUND ART

An NMR apparatus can obtain useful data for structural analysis of various organic compounds such as a chemical shift amount of each atom or a spin-spin coupling constant, and a magnet using a superconducting material is used because a large quantity of information can be analyzed in detail, when a ferromagnetic field is used. The NMR apparatus is configured with a magnet which generates a static magnetic field, a coil which generates a high-frequency pulse and detects an NMR signal, a receiver which receives an NMR signal, a system controller, and the like. As the magnet, a superconducting magnet is preferable from the viewpoints of strength of a magnetic field, stability, and uniformity. An MRI apparatus which traces a chemical reaction occurring in a tissue or an organ utilizing an NMR phenomenon and obtains a perspective brain sectional image, for example, is a representative example used in medical field of NMR.

The MRI apparatus is configured with a magnet which is a static magnetic field generating unit, a tilted magnetic field for applying spatial information to a signal, a high-frequency electromagnetic wave irradiation system, an NMR signal detection system, a probe coil which surrounds an inspection object such as a human body and performs high-frequency electromagnetic radiation or signal detection, a controller which controls these units and processes obtained signals, and the like. The MRI apparatus irradiates an inspection target located in the presence of the static magnetic field with high-frequency electromagnetic waves and visualizes an image of spatial distribution of nuclides generating a signal by the obtained NMR signal. When the MRI apparatus is used, it is safe because radioactive rays are not used, sufficient resolution is obtained, and practical advantages are extremely high.

A magnetic separation and cleaning apparatus which uses a fine woven metal wire net as a water separation film, generates a magnetic floc by adding a flocculant and magnetic powder into raw water having polluted particles such as sludge, separates the magnetic floc using the net, and performs magnetic separation and removal of the magnetic floc collected by the net with the magnetic field from the magnetic field generating apparatus to collect high-concentration sludge is provided as an example of a cleaning apparatus using the magnetic field, for the purpose of solid-liquid separation or the like.

In addition, a magnetic induction apparatus which performs magnetization by coupling a medical agent with a magnetic object, injects the magnetized material into a blood vessel, and applies the magnetic field from the magnetic field generating apparatus to an affected area such as a tumor to concentrate the medical agent is provided as an example of an induction apparatus using the magnetic field, for the purpose of induction of a medical agent.

The magnetic field generating apparatus using such technologies generally improves performance of a magnetic force for sensitivity or induction, when higher magnetic field strength is provided. Accordingly, a superconducting magnet using a superconducting coil formed of a metallic superconducting wire rod such as niobium-titanium may be used for formation of a main magnetic field of the magnetic field generating apparatus. This coil is used by being cooled at an extremely low temperature using liquid helium, and accordingly, a large amount of expensive liquid helium is necessary. Thus, the operating cost may be increased. Meanwhile, the superconducting magnet using the superconducting coil formed of the metallic superconducting wire rod may be directly cooled in a refrigerating machine. In this cooling system, a liquid reservoir can be removed because liquid helium is not necessary, and the apparatus can be miniaturized by a thermal conduction structure with a refrigerating machine. However, since it is necessary that the superconducting coil is cooled to a temperature of liquid helium by the refrigerating machine, the size of the refrigerating machine is increased and a large quantity of electric power is consumed. As a result, the size of the entire apparatus including the refrigerating machine may be increased or the operating cost may be increased.

As a small-sized unit which generates a ferromagnetic field with a simple configuration, an apparatus using a high-temperature superconducting bulk body to be directly cooled with the refrigerating machine, instead of the superconducting magnet formed of a low-temperature superconducting coil of the related art is used. In this apparatus, the high-temperature superconducting bulk body is sealed in a vacuum insulating container and the high-temperature superconducting bulk body is used as a superconducting magnet by being cooled by the refrigerating machine. As a material of the high-temperature superconducting bulk body, an oxide superconducting bulk body representing a main component as RE-Ba-Cu-O is used, for example. Herein, RE represents yttrium (element symbol Y), samarium (Sm), lanthanum (La), neodymium (Nd), europium (Eu), gadolinium (Gd), erbium (Er), and ytterbium (Yb) and is at least one kind or a combination of two or more kinds thereof. The oxide superconducting body has anisotropy in superconductivity due to the crystal orientation thereof and has higher critical current density in a direction orthogonal to a c axis of a crystal axis, compared to that of other crystal orientations. Accordingly, when the c axis of the crystal axis is oriented in one direction in a magnetic flux, an excellent magnetic field can be trapped. However, since it is difficult to control crystal growth in a c axis direction, a plurality of superconducting bulk bodies are used as the superconducting bulk magnet by laminating the plurality thereof in the c axis direction.

As a laminating method, a method of bonding the superconducting bulk bodies by a resin or the like or a method of performing bolt hole processing on rings provided on an outer periphery of the high-temperature superconducting bulk body and performing screw fastening with respect to the rings is used. JP-A-2002-006021, for example, discloses that "a conductive member 17 having high thermal conductivity holds two high-temperature superconducting bodies 20 and comes into contact with a cooling unit 23 to apply the same temperature to the two high-temperature superconducting bodies 20" and a laminating method by bonding.

The magnet using the high-temperature superconducting bulk body performs superconductive transition at a higher temperature, compared to that of the helium cooling type superconducting magnet of the related art, and therefore, it is possible to increase the operating temperature of the refrigerating machine. Accordingly, it is possible to simplify an insulation structure and to use a small-sized refrigerating machine, compared to the case of the helium cooling type superconducting magnet. In addition, since the cooling can be performed with low refrigeration power, it is possible to provide a small-sized magnetic field generating apparatus with a low operating cost, compared to the case of the helium cooling type superconducting magnet. At that time, the refrigerating machine for cooling the high-temperature superconducting bulk body generally operates a refrigerating cycle using helium gas as a working medium and a mechanism which compresses and expands helium gas is embedded therein. Examples of the type of the refrigerating machine include a compressor integrated type in which a compressor on a heat radiation side and an expander which performs cooling by a cold head unit are directly connected to each other, and a split type in which the compressor and the expander are connected to each other through a narrow tube and are separated from each other. In the split type among these, pressure loss occurs when helium gas flows through the narrow tube, and accordingly, cooling efficiency is deteriorated compared to that of the compressor integrated type. In addition, since the compressor and the expander are separated from each other, the size of the refrigerating machine may be increased compared to that of the integrated type. From such problems, the compressor integrated type refrigerating machine is desired as the cooling device of the high-temperature superconducting bulk body.

### SUMMARY OF THE INVENTION

A superconducting bulk body is generally used as a columnar or cylindrical shape so that an axis direction of the columnar or cylindrical shape is a crystal c axial direction so that electrical current flows in a direction of crystals a and b axes having great critical current of a high-temperature superconducting bulk body. At that time, since it is difficult to obtain a structure of a high-temperature superconducting bulk body having a great thickness in the axial direction, a plurality of thin high-temperature superconducting bulk bodies are generally laminated in the axial direction, but in order to increase a volume of the high-temperature superconducting bulk body, it is necessary to increase an outer diameter of the high-temperature superconducting bulk body as much as possible in a vacuum insulating space. Meanwhile, the bonding perf ormedby the resin or the like is one example of the laminating and fixing method disclosed in JP-A-2002-006021, but the bonded material may be peeled off due to thermal stress at the time of the cooling at a low temperature or an electromagnetic force when generating a magnetic field in the high-temperature superconducting bulk body. In addition, since a material used for bonding has low thermal conductivity compared to that of the high-temperature superconducting bulk body, heat resistance increases when a thickness of a bonded layer is increased, and the high-temperature superconducting bulk body may not be cooled to a predetermined temperature. As a result, the strength of the generated magnetic field may be low. As a method for solving such problems, a method of providing a screw hole in a fixing ring provided on the outer periphery of the high-temperature superconducting bulk body and fixing the superconducting bulk bodies with a bolt is provided, but it is necessary to provide a space for a screw hole to which the bolt is inserted and the size of the high-temperature superconducting bulk body may not be increased.

An object of the invention is to provide a laminating and fixing method of a small-sized and high-magnetic-field superconducting bulk body and a magnetic field generating apparatus.

In order to achieve the above-mentioned object, according to an aspect of the present invention, there is provided a laminated and fixed structure of a plurality of superconducting bulk bodies, in which a fixing ring which is provided for each superconducting bulk body and fixed to an outer periphery of the superconducting bulk body includes a screw portion, and the adjacent bulk bodies are laminated and fixed by fitting the screw portions of the adjacent fixing rings at the time of laminating.

According to the aspect of the invention, it is possible to obtain a small-sized and high-magnetic-field magnetic field generating apparatus.

### BRIEF DESCRIPTION OF THE DRAWINGS

Fig. 1 is a diagram showing a configuration of a magnetic field generating apparatus in First Example of the invention.
Fig. 2 shows an enlarged diagram of a cross section of a bulk body and a fixing ring from a view in the same direction as in Fig. 1.
Fig. 3 shows a side view of an appearance of a fixing ring.
Fig. 4 shows a flowchart of a magnetizing operation of a magnetic field generating apparatus.
Fig. 5 is a sectional view when the magnetic field generating apparatus is inserted into a magnetizing apparatus.
Fig. 6 is a sectional view showing a bulk body and a fixing ring of a magnetic field generating apparatus of Second Example.
Fig. 7 shows a side view of an appearance of an inner side ring and an outer side ring.
Fig. 8 is a sectional view showing another example of the bulk body of the magnetic field generating apparatus of First Example.

### DETAILED DESCRIPTION OF THE INVENTION

Hereinafter, a magnetic field generating apparatus according to an embodiment of the invention will be described with reference to the drawings.

### Example 1

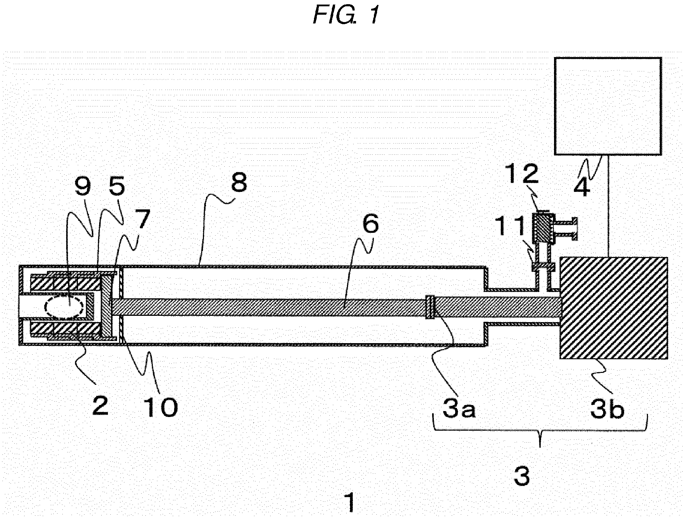

Fig. 1 is a diagram showing a configuration of a magnetic field generating apparatus 1 in First Example of the invention.

The magnetic field generating apparatus 1 is a magnetic field generating apparatus which generates a magnetic field in a magnetic field generating space 9 by performing magnetizing which will be described later and continuing cooling with respect to a high-temperature superconducting bulk body (hereinafter, referred to as a bulk body) 2.

The magnetic field generating apparatus includes the bulk body 2, a refrigerating machine 3, a power supply unit 4, a fixing ring 5, a thermal conductor 6, a cooling stage 7, a vacuum container 8, the magnetic field generating space 9, a support 10, an exhaust port 11, and a valve 12.

The bulk body 2 serves as a superconducting permanent magnet by being cooled by the refrigerating machine 3 which will be described later. A material of the bulk body 2 is an oxide superconducting bulk body representing a main component as RE-Ba-Cu-O, for example. Herein, RE represents yttrium (element symbol Y), samarium (Sm), lanthanum (La), neodymium (Nd), europium (Eu), gadolinium (Gd), erbium (Er), and ytterbium (Yb) and is at least one kind or a combination of two or more kinds thereof.

When synthesizing a yttrium-based, neodymium-based, or samarium-based oxide superconductor having a superconductivity transition temperature equal to or higher than 90 K as the absolute temperature, the synthesis is performed by a so-called fusion method of first overheating and fusing a raw material at a temperature higher than a melting point and solidifying the material again. At that time, a high-temperature superconducting bulk body formed with a growth of coarse crystals is obtained. A structure in which insulator phases are finely dispersed is obtained in a parent phase to be superconductive, a pinning point caused by the presence of this diffusion layer traps a magnetic flux, and the superconducting bulk body serves as a pseudo permanent magnet. Silver having a particle diameter equal to or smaller than 50 µm may be added for synthesis of the superconducting bulk body. The silver is dispersed in the structure without significantly damaging the performance of the superconducting phases, can realize improvement of mechanical strength by preventing spread of cracks on a sample or promotion of crystal growth by decreasing a melting point, and can contribute to a crystal orientation by preventing an increase of the melting point by applying a difference in temperature with that of a seed crystal.

The oxide superconducting body has anisotropy in superconductivity due to the crystal orientation thereof and has higher critical current density in a direction orthogonal to a c axis of a crystal axis, compared to that of other crystal orientations. Accordingly, when the c axis of the crystal axis is oriented in one direction, an excellent magnetic field can be trapped. Therefore, excellent trapped magnetic field characteristics are obtained by orienting the c axis in a magnetic field direction in which the high-temperature superconducting bulk body is magnetized.

The bulk body 2 is worked in a cylindrical shape, and fixed to the cooling stage 7 after fixing an outer periphery thereof with the fixing ring 5. A method of attaching the fixing ring 5 with respect to the bulk body 2 will be described later in detail. When generating the magnetic field in the bulk body 2, a Lorentz force is applied to the outer side of the bulk body 2 in a radial direction by the current flowing inside the bulk body and the external magnetic field. Accordingly, it is necessary to prevent fracture of the bulk body due to the Lorentz force by the fixing ring 5. Thus, as a material of the fixing ring 5, it is preferable to use a material having a coefficient of linear expansion which is equivalent or higher than that of the bulk body 2, in order to constantly apply compressive stress to the center of the bulk body 2 in the radial direction from the fixing ring 5 at the time of cooling. As a specific material, metal such as stainless steel or aluminum or fiber reinforced plastics (FRP) having high strength may be used. As the fiber used in the FRP, an alumina or glass fiber or carbon fiber is used, for example.

The refrigerating machine 3 which cools the bulk body 2 is formed of a cold head 3a which is a cooling end and a refrigerating machine main body 3b. The refrigerating machine 3 cools the cold head 3a by supplying a power source to the refrigerating machine main body 3b by the power supply unit 4. The refrigerating machine 3 can be, for example, miniaturized by using a Stirling refrigerating machine which is a compressor integrated type. In addition, the same effects are also obtained by using a split-type GM cycle refrigerating machine, a Solvay-cycle refrigerating machine, a Stirling refrigerating machine, or a pulse tube refrigerating machine. The refrigerating machine main body 3b at this time is configured with an expander, a compressor, and a narrow tube which connects the expander and the compressor and circulates helium gas. Accordingly, the size of the apparatus may be increased or refrigerating efficiency may be decreased due to pressure loss of the narrow tube, compared to the case of the compressor integrated type. A compressor heat radiation unit radiates heat by an air-cooling or water-cooling apparatus (not shown).

The thermal conductor 6 is connected to the refrigerating machine cold head 3a. As a material of the thermal conductor 6, it is preferable to use oxygen-free copper or aluminum, for example, having high thermal conductivity at a low temperature. In addition, a structure of a heat pipe using helium gas operating at a low temperature as a working medium can also be used. The thermal conductor 6 is fixed to the vacuum container 8 through the support 10.

The support 10 is provided to support between the vacuum container 8 which is at room temperature and the bulk body 2 which is cooled to a low temperature. As a material of the support 10, it is necessary to use a material such as FRP having low thermal conductivity, in order to prevent heat from being transmitted to the low temperature side.

The exhaust port 11, the valve 12, and a vacuum pump (not shown) are connected to each other and the vacuum container 8 exhausts air as described above, and the inner portion is in a vacuum insulation state. Although not shown, a super-insulator (heat-insulating sheet) may be laminated between the bulk body 2, the fixing ring 5, the thermal conductor 6, the cooling stage 7, and the cold head 3a at a low temperature and the vacuum container 8 at room temperature, in order to prevent penetration of radiant heat to the portion at a low temperature. By doing so, since it is possible to maintain the bulk body 2 at a lower temperature, great critical current density of current flowing into the superconducting body is obtained, and thus, it is possible to provide a higher-magnetic-field magnetic field generating apparatus.

The bulk body 2 is fixed in the vacuum container 8 by the support 10. The bulk body 2 is in a vacuum insulating state from the atmosphere side, by exhausting the air in the vacuum container 8 by a vacuum pump (not shown). The bulk body 2 is thermally connected to the cold head 3a which is a cooling end of the refrigerating machine by the thermal conductor 6 in the vacuum insulating space.

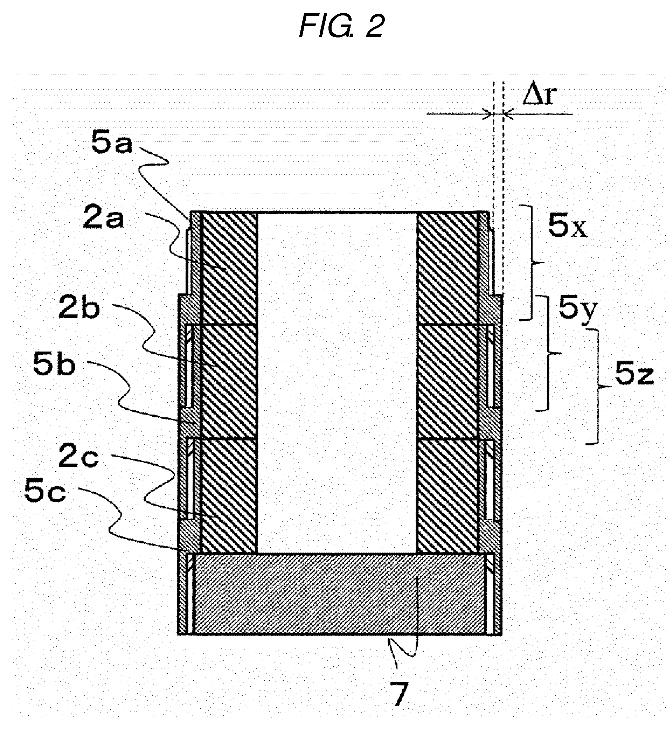

Next, the fixing ring 5 of the magnetic field generating apparatus 1 will be described with reference to Fig. 2.

Fig. 2 shows an enlarged diagram of a cross section of the bulk body 2 and the fixing ring 5 from a view in the same direction as in Fig. 1.

The bulk body 2 is fixed by shrink-fitting of a fixing ring 5a to a hollow cylindrical bulk body 2a. A bulk body 2b and a fixing ring 5b, and a bulk body 2c and a fixing ring 5c are also fixed to each other by the same method. By performing shrink-fitting of the ring, the compression pressure is constantly applied to the bulk body 2 from the fixing ring 5.

Herein, the fixing ring 5a includes a portion 5x to be shrink-fitted with the bulk body 2a and a portion 5y for connecting the adjacent laminatedbulk body 2b and the shrink-fit fixing ring 5b to each other. In addition, the fixing ring 5b includes a portion 5z which is shrink-fitted with the bulk body 2b. Since the bulk bodies 2a and 2b are laminated and fixed, a screw portion (a male screw portion and a female screw portion) is provided on a surface of the portion 5y opposing the portion 5z and a surface of the portion 5z opposing the portion 5y, in this example. Specifically, the female screw portion is provided along a circumferential direction of the fixing ring 5b of the portion 5y, the male screw portion is provided along a circumferential direction of the fixing ring 5a of the portion 5z, and the bulk bodies 2a and 2b are laminated and fixed by these screw portions. In the same manner as described above, the bulk bodies 2b and 2c, and the bulk body 2c and the cooling stage 7 are also fixed by the same mechanism. In this example, the female screw portion is provided in the portion 5y and the male screw portion is provided in the portion 5z, but the male screw portion may be formed in the portion 5y and the female screw portion may be formed in the portion 5z. As described above, by providing the screw portions along the circumferential direction of the fixing ring 5, a hole for bolt fixation is not necessary to be provided, and Δr which is a length in the radial direction used for lamination can be decreased, compared to that in the lamination using a bolt in the related art. In addition, the bulk bodies can be screw-fixed by the fixing ring, and accordingly, it is possible to control the surface pressure between the bulk bodies.

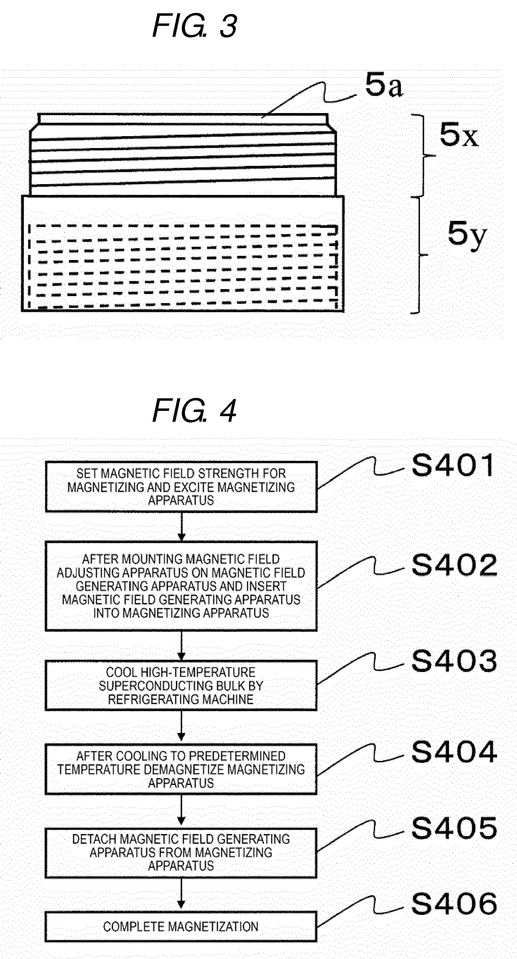

Fig. 3 shows a side view of the appearance of the fixing ring 5a.

The male screw is formed on the outer peripheral surface of the portion 5x. Meanwhile, the female screw is formed on the inner peripheral surface of the portion 5y. The same configuration is also used for the fixing rings 5b and 5c.

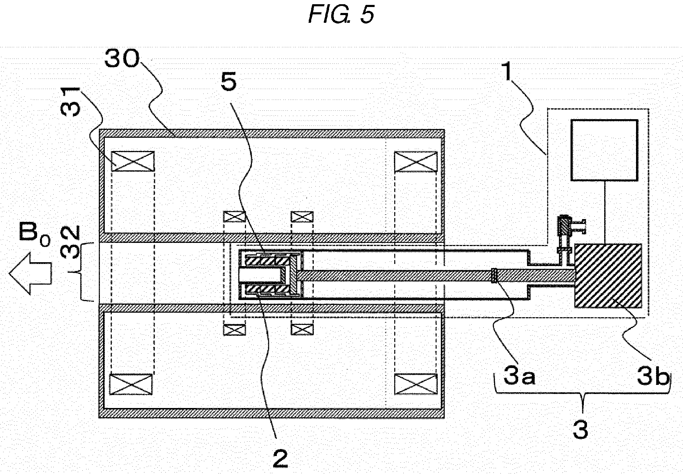

Next, magnetizing of the magnetic field generating apparatus 1 will be described with reference to Fig. 4 and Fig. 5.

Fig. 4 shows a flowchart of a magnetizing operation of the magnetic field generating apparatus 1.

Fig. 5 is a sectional view when the magnetic field generating apparatus 1 is inserted into the magnetizing apparatus 30.

In Fig. 5, the magnetizing apparatus 30 includes an electromagnet 31 for magnetic field generation and a space 32 for the magnetic field generating apparatus 1 to be inserted.

First, the magnetizing apparatus 30 sets a magnetic field strength for magnetization and performs excitation until the set magnetic field strength is obtained (S401). The magnetizing apparatus 30 is configured with the electromagnet 31 by a large-sized superconducting coil, for example, and is cooled to a temperature equal to or lower than a superconductivity transition temperature by an external cooling apparatus (not shown). By controlling the current flowing to the superconducting coil by the external cooling apparatus (not shown), it is possible to generate a predetermined static magnetic field in a direction of Bo in Fig. 5. In addition, it is preferable to adjust the magnetic field by the superconducting shim coil, in order to set the magnetic field generated to be spatially uniform. Since the superconducting bulk body is magnetized with uniformity which is equal to or smaller than that of the excitation magnetic field of the magnetizing apparatus, high magnetic field uniformity of the magnetizing apparatus is preferable. For example, in a case of usage with NMR or MRI, it is desirable that distribution of the set magnetic field strength in the space in which the magnetic field generating apparatus 1 is inserted is set to be equal to or smaller than approximately several ppm.

Next, the magnetic field generating apparatus 1 is inserted into the magnetizing apparatus 30 (S402). It is necessary that the magnetic field which has a strength of approximately 4 to 10 tesla, is generated, in order to magnetize the magnetic field higher than that of the bulk body in the center of the magnetic field of the magnetizing apparatus 30. Accordingly, in the space in the end portion of the magnetizing apparatus 30, a leakage magnetic field having a strength of several tesla is present and the space having 0.1 tesla or lower is in a position separated from the end portion by 0.4 m to 0.7 m. At that time, in a case where the refrigerating machine 3 is a Stirling cycle refrigerating machine which is a compressor integrated type or a split-type GM cycle refrigerating machine, a motor of the compressor or the expander is mounted in the refrigerating machine main body 3b, and a steel sheet or a permanent magnet is used, and accordingly, the refrigerating machine cannot be operated in the high-magnetic field space. It is necessary that the refrigerating machine is operated in the magnetic field space of the end portion of the magnetizing apparatus. In addition, even in a case of a split type pulse tube refrigerating machine not including a mechanical driving unit or even in a case of cooling by circulating a coolant such as helium gas, a narrow tube for connection is attached, and this does not fit in the space in the magnetizing apparatus, and accordingly, it is necessary that the cooling apparatus is attached to an outer portion with respect to the magnetizing apparatus 30. The magnetic field generating apparatus 1 is disposed so that the center of the bulk body 2 is in the magnetic field center of the magnetizing apparatus 30 and is fixed to the magnetizing apparatus 30, if necessary, with a nonmagnetic, for example, aluminum or FRP support jig (not shown). Accordingly, the cooling of the bulk body 2 which will be described later is completed, the magnetic flux is trapped in the bulk body, and when the magnetic field of the magnetizing apparatus 30 is demagnetized, it is possible to prevent movement of the magnetic field generating apparatus 1 towards the center of the magnetizing apparatus 30 by a magnetic force.

Next, the bulk body 2 is cooled by the refrigerating machine 3 (S403). The bulk body 2 is turned into a superconducting state by performing cooling, the pinning force is operated, and the flux penetrating through the inside is trapped.

After the bulk body 2 is cooled to a predetermined temperature, the magnetizing apparatus 30 is demagnetized (S404). The temperature at that time is desirably higher than a lowest arrival temperature of the magnetic field generating apparatus 1 by approximately several K to 10 K. This is because it is possible to prevent time variation of the magnetic field of the bulk body 2 by overcooling to the lowest arrival temperature after the magnetizing. When the magnetic field of the magnetizing apparatus 30 is demagnetized, an induced current is generated in the bulk body 2 by electromagnetic induction so that the trapped magnetic field is maintained, and the induced current continuously flows as supercurrent. At that time, since the induced current flows to the bulk body 2 in a state where the magnetic field is generated from the magnetizing apparatus, a Lorentz force is generated to the outer side of the bulk body 2 in a radial direction. In order to prevent fracture of the bulk body 2 due to the Lorentz force, it is necessary that the fixing ring 5 is fixed to the bulk body 2 in a state where the compressive stress is applied, and a thickness of a portion inner than the screw portion is designed so as to withstand the Lorentz force.

After the demagnetizing of the magnetizing apparatus 30 is completed, the magnetic field generating apparatus 1 is detached from the magnetizing apparatus 30 (S405) and the magnetizing is completed (S406). When the current flowing through the inside is equal to or smaller than a critical current value, the bulk body 2 can trap the magnetic field so that the original magnetic field is copied. In a case where the bulk body 2 is a cylindrical shape as in the example, a uniformmagnetic field from the magnetizing apparatus is generated in the magnetic field generating space 9 in the magnetic field generating apparatus 1, and is useful in the NMR or MRI, for example.

According to the example, since the bulk body can be screw-fixed by the fixing ring, it is possible to control the surface pressure on the laminated surface between bulk bodies. When the surface pressure between the bulk bodies is great, heat resistance can be decreased, and as a result, it is possible to decrease a difference in temperature between the bulk bodies. Accordingly, by controlling the surface pressure between the laminated bulk bodies to be high, a difference in temperature between the bulk body 2c close to the cooling stage 7 and the bulk body 2a far from the cooling stage is decreased, and the bulk body 2a far from the cooling stage can be cooled to a lower temperature. Therefore, it is possible to increase the critical current which can flow through the bulk body 2 and to provide a magnetic field generating apparatus with a higher magnetic field.

In addition, a variation due to the insulator phases finely dispersed is present in the bulk body 2. Accordingly, even when fracture of the bulk body 2 is prevented by the fixing ring 5 by design, a part of the plurality of bulk bodies 2 may be fractured by the Lorentz force. At that time, according to the example, since the bulk bodies 2 are fixed by fastening a screw in the fixing ring 5, it is easy to perform detachment compared to the fixing performed by the bonding of the related art, and it is easy to exchange the fractured bulk body 2.

### Example 2

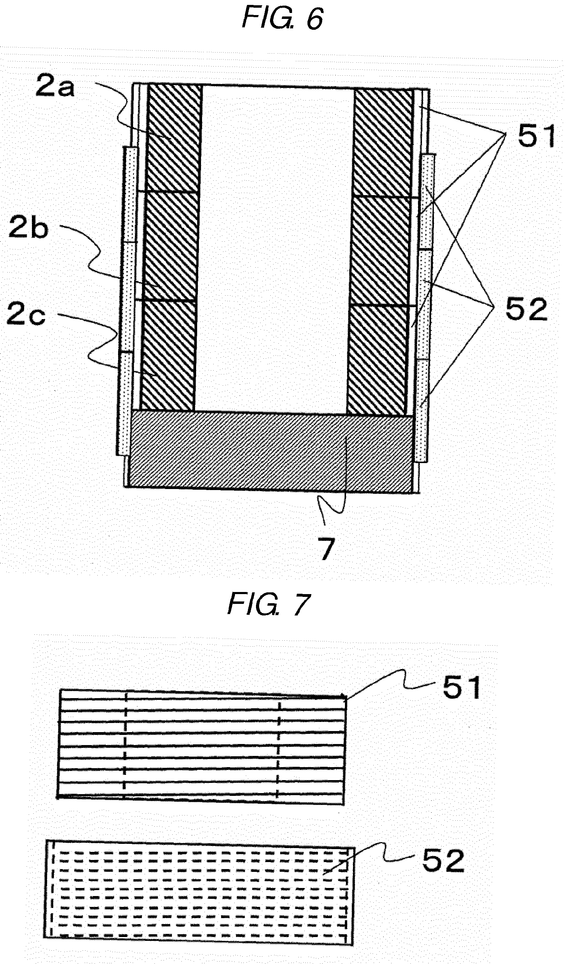

Fig. 6 is a sectional view showing the bulk body 2 and the fixing ring 5 of the magnetic field generating apparatus 1 of Second Example.

In the example, the fixing ring 5 has a two-layered structure of an inner side ring 51 and an outer side ring 52 and a structure in which a screw portion is provided in the contact portion of each ring and the bulk bodies 2 are laminated and fixed.

Fig. 7 shows a side view of an appearance of the inner side ring 51 and the outer side ring 52.

A male screw is provided on the outer peripheral surface of the inner side ring 51 and a female screw is provided on the inner peripheral surface of the outer side ring 52. In the same manner as in Example 1, the male screw and the female screw may be formed in a reversed manner.

In addition, since the compressive stress is applied to the bulk body 2 by using a material having a small coefficient of linear expansion in the order of the bulk body 2, the inner side ring 51, and the outer side ring 52, as a material of each member at this time, it is possible to prevent the fracture of the bulk body 2 by the Lorentz force. Even in this example, it is possible to set a state where the compressive stress is constantly applied to the bulk body 2, by shrink-fitting the inner side ring 51 to fix the bulk body 2.

By setting such a configuration, the inner side ring 51 and the outer side ring 52 can be configured with separate materials. For example, by setting the inner side ring 51 as oxygen-free copper having great thermal conductivity and the outer side ring 52 as stainless steel having great Young's modulus, it is possible to decrease the heat resistance from the cooling stage 7 to the bulk body 2 by the inner side ring 51, and it is possible to prevent fracture of the bulk body by the Lorentz force by the outer side ring 52. In addition, heat is transmitted to the fixing ring and bulk body by radiation from the external vacuum container. At that time, when considering heat transmitted from the side surface of the fixing ring 5, the inner side ring 51 and the outer side ring 52 are fixed by a screw cut in a circumferential direction of the ring. Accordingly, a thermal conductive flow path of both rings is only a screw thread or screw bottom, or line contact, and heat resistance is increased. Therefore, the heat entered is mainly transmitted towards the cooling stage 7 in a laminated direction and it is advantageous that an increase in temperature of the bulk body 2 can be prevented. Thus, it is possible to cool the bulk body 2 at a lower temperature and to provide a magnetic field generating apparatus which can generate a higher magnetic field.

### Example 3

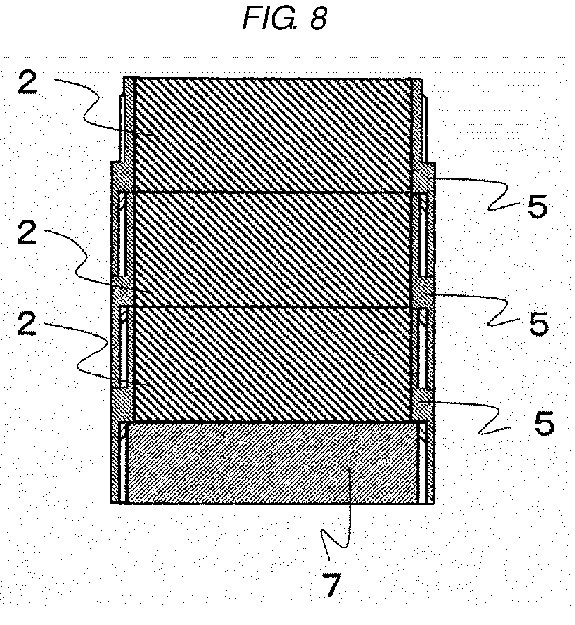

Fig. 8 is a sectional view showing another example of the bulk body 2 of the magnetic field generating apparatus of First Example.

In the example, the bulk body 2 is worked in a cylindrical shape and a magnetic field on the cylindrical surface is used. In the bulk body 2 having a hollow cylindrical shape of Example 1 and Example 2, a uniform magnetic field is generated in the magnetic field generating space 9 in the cylindrical bulk body 2, but in this example, the magnetic field is attenuated by being separated from the surface of the bulk body 2 and the magnetic field gradient is generated. With such configurations, it is possible to realize a small-sized magnetic separation apparatus or a magnetic induction apparatus using the magnetic field space having gradient of the magnetic field generating space 9. In the example, the shape of the bulk body 2 is set as a cylindrical shape, but the same effects are obtained, when a solid shape such as a triangular column or a square column is set. At that time, the inner peripheral side of the fixing ring 5 is set as the shape of the bulk body 2 and it is necessary that the outer peripheral side has a cylindrical shape so as to be screw-fixed.

The bulk bodies 2 of the example can be laminated and fixed by the fixing ring 5 of First Example and Second Example. Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A laminated and fixed structure of a plurality of superconducting bulk bodies (2, 2a-2c),
wherein a fixing ring (5, 5a-5ac) which is provided for each superconducting bulk body (2, 2a-2c) and fixed to an outer periphery of the superconducting bulk body (2, 2a-2c) includes a screw portion, and
the adjacent bulk bodies (2a-2c) are laminated and fixed by fitting the screw portions of the adjacent fixing rings (5, 5a-5ac) at the time of laminating.

2. The laminated and fixed structure of a plurality of superconducting bulk bodies (2a-2c) according to claim 1,
wherein the fixing ring (5, 5a-5ac) includes a first portion to be fixed to the outer periphery of the superconducting bulk body (2, 2a-2c) and a second portion to be fit to the first portion fixed to the adjacent superconducting bulk body (2, 2a-2c), and
the screw is cut in the first portion and the secondportion in a circumferential direction of the ring.

3. The laminated and fixed structure of a plurality of superconducting bulk bodies (2a-2c) according to claim 2,
wherein a screw portion is provided on an outer peripheral side of the ring in the first portion, and a screw portion is provided on an inner peripheral side of the ring in the second portion.

4. A laminated and fixed structure of a plurality of superconducting bulk bodies (2a-2c), comprising:
an inner side ring (51) which is provided for each superconducting bulk body (2, 2a-2c) and fixed to an outer periphery of the superconducting bulk body (2, 2a-2c), and in which a screw is cut in a circumferential direction in the outer periphery of the ring; and
an outer side ring (52) in which a screw is cut in a circumferential direction in the inner periphery, in order to laminate and fix adjacent superconducting bulk bodies (2a-2c) through the inner side ring (51), and
wherein the plurality of superconducting bulk bodies (2a-2c) are laminated and fixed by screw-fixing the inner side ring (51) and the outer side ring (52).

5. The laminated and fixed structure of a plurality of superconducting bulk bodies (2a-2c) according to claim 4,
wherein coefficients of linear expansion of the superconducting bulk body (2, 2a-2c), the inner side ring (51), and the outer side ring (52) descend in this order.

6. The laminated and fixed structure of a plurality of superconducting bulk bodies (2a-2c) according to claim 4,
wherein a Young's modulus of the inner side ring (51) is smaller than a Young's modulus of the outer side ring (52).

7. A magnetic field generating apparatus which generates a steady magnetic field in a superconducting bulk body (2, 2a-2c) formed by the laminated and fixed structure of a plurality of superconducting bulk bodies (2a-2c) according to claim 1 or 4, the apparatus comprising:
a cooling device which cools the super conducting bulk body (2, 2a-2c);
a thermal conductor (6) which thermally connects the superconducting bulk body (2, 2a-2c) and the cooling device to each other; and
a vacuum container (8) which is accommodated in the device for vacuum insulating.
